Europäisches Patentamt

European Patent Office

Office européen des brevets

(19)

(11) **EP 0 656 170 B1**

(12) **FASCICULE DE BREVET EUROPEEN**

(45) Date de publication et mention
de la délivrance du brevet:
**22.04.1998 Bulletin 1998/17**

(21) Numéro de dépôt: **93913163.7**

(22) Date de dépôt: **21.06.1993**

(51) Int Cl.6: **H05H 1/00**, F03H 1/00

(86) Numéro de dépôt international:
**PCT/FR93/00609**

(87) Numéro de publication internationale:
**WO 95/01085 (05.01.1995 Gazette 1995/02)**

(54) **DISPOSITIF DE MESURE DE VARIATIONS DE LA POUSSEE D'UN MOTEUR A PLASMA A DERIVE FERMEE D'ELECTRONS**

VORRICHTUNG ZUR MESSUNG DER SCHUBSCHWANKUNGEN EINES PLASMAMOTORS MIT GESCHLOSSENEM ELEKTRONENDRIFT

DEVICE FOR MEASURING CHANGES IN THE THRUST OF A PLASMA ENGINE WITH CLOSED ELECTRON DRIFT

(84) Etats contractants désignés:
**CH DE ES FR GB IT LI NL SE**

(43) Date de publication de la demande:
**07.06.1995 Bulletin 1995/23**

(73) Titulaire: **SOCIETE NATIONALE D'ETUDE ET DE CONSTRUCTION DE MOTEURS D'AVIATION, "S.N.E.C.M.A."**
**75015 Paris (FR)**

(72) Inventeurs:
• **MOROZOV, Alexei**
**Moscou, 123098 (RU)**
• **BOUGROVA, Antonina**
**Moscou, 129041 (RU)**
• **KHARCHEVNIKOV, Vadim**
**Moscou (RU)**
• **VALENTIAN, Dominique**
**F-78710 Rosny (FR)**

(74) Mandataire: **Thévenet, Jean-Bruno et al**
**Cabinet Beau de Loménie**
**158, rue de l'Université**
**75340 Paris Cédex 07 (FR)**

(56) Documents cités:
• **SOVIET PHYSICS TECHNICAL PHYSICS vol. 35, no. 2 , Février 1990 , NEW YORK US pages 238 - 239 BARKALOV ET AL. 'Experimental study of the azimuthal electron drift current in Hall accelerators'**
• **SOVIET PHYSICS TECHNICAL PHYSICS vol. 25, no. 10 , Octobre 1980 , NEW YORK US pages 1307 - 1309 BUGROVA ET AL. 'Determination of the radial center of gravity of an azimuthal drift current in accelerators with closed electron drift'**
• **IBM TECHNICAL DISCLOSURE BULLETIN vol. 34, no. 11 , Avril 1992 , NEW YORK US page 424-XP303314 'Non-contaminating electron density monitor for RF induction plasmas'**
• **SOVIET PHYSICS TECHNICAL PHYSICS vol. 23, no. 3 , Mars 1978 , NEW YORK US pages 376 - 377 DEM'YANENKO ET AL. 'Induction method for measuring the azimuthal drift current in a Hall-current accelerator'**
• **PROCEEDINGS OF THE 10TH SYMPOSIUM ON SPACE NUCLEAR POWER AND PROPULSION - 10-14 JAN. 1993 vol. 271/3 , ALBUQUERQUE, USA pages 1327 - 1334 SCHEUER ET AL. 'Initial operation of a 10 ms, quasi-steady, multi-megawatt, coaxial plasma thruster'**

**Description**

Domaine de l'invention

La présente invention a pour objet un dispositif de mesure de variations de la poussée d'un moteur à plasma à dérive fermée d'électrons comprenant un canal annulaire principal d'ionisation et d'accélération, au moins une cathode creuse disposée à l'extérieur du canal principal en aval de celui-ci, une anode, des moyens d'alimentation en gaz ionisable associés respectivement à la cathode creuse et à l'anode, et des moyens de création d'un champ magnétique.

Art antérieur

Les moteurs électriques sont destinés essentiellement aux applications de propulsion spatiales. En tant que sources d'ions ou de plasma, ils sont utilisés pour des applications terrestres, notamment pour l'usinage ionique. Grâce à leur haute impulsion spécifique (de 1500 à 6000s) ils permettent des gains de masse considérables sur les satellites par rapport à des moteurs utilisant la propulsion chimique.

Les propulseurs ioniques peuvent se répartir en plusieurs catégories. La plupart des propulseurs ioniques ont en commun d'avoir des fonctions d'ionisation et d'accélération des ions clairement séparées.

Les moteurs à plasma du type "à dérive fermée d'électrons" encore appelés "moteurs à plasma stationnaire" ou, aux Etats-Unis d'Amérique, "moteurs de Hall", se distinguent des autres catégories par le fait que l'ionisation et l'accélération ne sont pas différenciées et que la zone d'accélération comporte un nombre d'ions et d'électrons égal, ce qui permet d'éliminer tout phénomène de charge d'espace.

Les propulseurs ioniques conventionnels produisent une poussée F qui peut se déduire analytiquement de la tension d'accélération V et de l'intensité I du faisceau d'ions selon la formule suivante :

$$F = a.k.I\,(M.V.)^{0.5} \tag{1}$$

où :

a : coefficient de correction pour la divergence du faisceau
k : coefficient de proportionnalité
I : courant d'ions
M : masse atomique de l'élément ionisé
V : tension nette d'accélération

Les moteurs à plasma stationnaires présentent une distribution de l'énergie des ions qui dépend en outre du régime de fonctionnement, il n'est ainsi pas possible de recourir à une formule analytique identique pour déterminer leur poussée.

Des moteurs à plasma stationnaire sont décrits dans un article de L.H. ARTSIMOVITCH et al. paru en 1974.

Un type de moteur à plasma amélioré du type à dérive fermée d'électrons est décrit dans la demande de brevet français 92 08744 déposée le 15 juillet 1992 et sera décrit sommairement en référence à la figure 1.

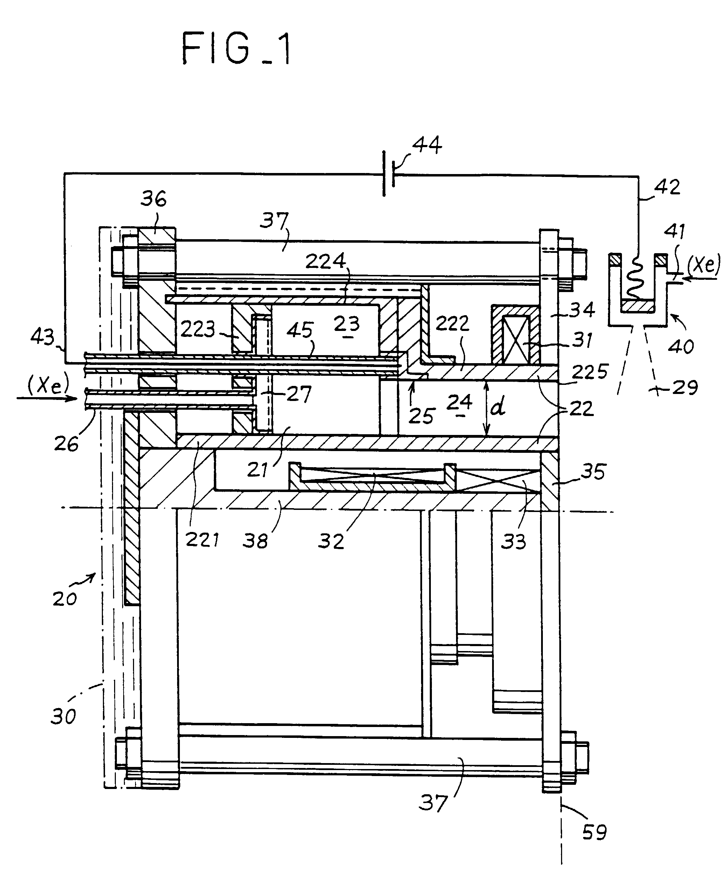

La figure 1 montre un exemple de moteur à plasma 20 à dérive fermée d'électrons qui comprend un ensemble de pièces 22 en matériau isolant délimitant un canal annulaire 21 formé en amont d'une première partie constituée par une chambre tampon 23 et en aval d'une deuxième partie constituée par un canal d'accélération 24.

La chambre annulaire 23 présente de préférence une dimension dans le sens radial qui est de l'ordre du double de la dimension dans le sens radial du canal annulaire d'accélération.

Une anode 25, reliée par une ligne électrique 43 à une source de tension continue 44, qui peut être par exemple de l'ordre de 200 à 400 V, est disposée sur les pièces isolantes 22 délimitant le canal annulaire 21, dans une zone située immédiatement en aval de la chambre tampon 23, à l'entrée du canal d'accélération 24. La ligne 43 d'alimentation de l'anode 25 est disposée dans un tube isolant 45 qui traverse le fond du moteur constitué par une plaque 36 formant culasse magnétique et des pièces 223, 224 en matériau isolant délimitant la chambre tampon 23.

Un tube 26 d'alimentation en gaz ionisable tel que du xénon traverse également la culasse 36 et le fond 223 de la chambre tampon 23 pour déboucher dans un distributeur annulaire de gaz 27 placé dans le fond de la chambre tampon 23.

Le canal 21 délimité par l'ensemble des pièces isolantes 22 est placé dans un circuit magnétique composé essentiellement de trois bobines 31, 32, 33 et de pièces polaires 34, 35.

Des pièces polaires planes externe 34 et interne 35 sont placées dans le plan de sortie du moteur à l'extérieur du canal d'accélération 24 et déterminent des lignes de champ magnétique qui, à la partie ouverte aval du canal d'accélération 24, sont sensiblement parallèles au plan de sortie 59 du moteur 20.

Le circuit magnétique constitué des pièces polaires 34 et 35 est fermé par un noyau central axial 38 et des barres de liaison 37 disposées à la périphérie du moteur selon une configuration essentiellement cylindrique, le noyau central 38 en matériau ferromagnétique et les barres de liaison 37 en matériau ferromagnétique étant en contact avec la culasse arrière 36. La culasse 36, qui est en matériau ferromagnétique et constitue le fond du moteur, peut être protégée par une ou plusieurs couches 30 de matériau super isolant thermiquement qui élimine le flux thermique rayonné vers le satellite.

Les électrons nécessaires au fonctionnement du moteur sont fournis par une cathode creuse 40 qui peut être de conception classique. La cathode 40, qui est reliée électriquement par une ligne 42 au pôle négatif de la source de tension 44, comporte un circuit 41 d'alimentation en gaz ionisable tel que du xénon, et se trouve placée en aval de la zone de sortie du canal d'accélération 24.

La cathode creuse 40 fournit un plasma 29 sensiblement au potentiel de référence d'où sont extraits les électrons se dirigeant vers l'anode 25 sous l'effet du champ électrostatique E dû à la différence entre l'anode 25 et la cathode 40.

Ces électrons ont une trajectoire de dérive en azimut dans le canal d'accélération 24 sous l'effet du champ électrique E et du champ magnétique H.

Typiquement, le champ à la sortie du canal 24 est de 12 000 à 16 000 $Am^{-1}$ (150 à 200 Oe).

Les électrons primaires sont accélérés par le champ électrostatique E, ils heurtent alors la paroi de l'isolateur 22, ce qui fournit des électrons secondaires d'énergie plus faible.

Les électrons entrent en collision avec les atomes neutres de xénon issus de la chambre tampon 23.

Les ions xénon ainsi formés sont accélérés par le champ électrostatique E dans le canal d'accélération 24.

Il n'y a pas de charge d'espace dans le canal d'accélération 24 en raison de la présence des électrons.

La neutralisation du faisceau d'ions est assurée par une partie des électrons issus de la cathode creuse 40.

La maîtrise du gradient de champ magnétique radial obtenue grâce à la disposition des bobines 31 à 33 et des pièces polaires 34 et 35 permet de séparer les fonctions d'accélération des ions de la fonction ionisation obtenue dans une zone proche de l'anode 25.

La régulation de ces moteurs peut être effectuée de différentes manières :

Selon une première méthode, le débit de gaz propulsif (du Xénon) est déterminé par de simples trous calibrés. Le moteur n'a alors aucune régulation active.

Selon une autre méthode, le courant de décharge est régulé par contre-réaction sur le débit de Xénon à l'aide d'une vanne ou d'un capillaire chauffé.

Cette dernière méthode est approximative car c'est le courant de décharge du moteur qui est régulé, et non la poussée. Il n'y a donc pas de garantie que la poussée y soit proportionnelle (on peut d'ailleurs constater des variations de ± 10 %).

Ces méthodes impliquent l'absence de mesure et de régulation de la poussée, ce qui amène les inconvénients suivants :

* au sol, pendant les essais de recette, il faut mesurer la poussée par une balance, ce qui constitue une disposition assez contraignante ;

* en vol :

   - lorsque deux moteurs sont en fonctionnement simultané, disposition répandue pour la correction Nord-Sud des satellites géostationnaires, un éventuel déséquilibre de poussée peut engendrer une perturbation d'attitude du satellite qu'il faut corriger par d'autres moteurs, alors qu'un dispositif de mesure et régulation de poussée permet d'annuler cette perturbation relative ;
   - la méconnaissance de l'impulsion délivrée par correction oblige à effectuer un suivi de trajectoire régulier.

Dans un article de Dem'yanenko et al intitulé « Induction method for measuring the azimuthal drift current in a Hall-current accelerator», paru dans la revue Soviet Physics Technical Physics, Volume 23, tome 3, mars 1978, New York, US, pages 376, 377, on a par ailleurs proposé d'utiliser des bobines de mesure disposées autour du canal d'accélération pour déterminer la grandeur et la position du centre de gravité du courant azimutal d'électrons dans le canal d'accélération.

Objet et description succincte de l'invention

La présente invention a pour but de permettre d'effectuer de façon simple et efficace une mesure des variations de la poussée d'un moteur à plasma à dérive fermée d'électrons.

L'invention vise encore à permettre la détermination aisée de la valeur de la poussée d'un moteur à plasma à partir de la mesure des variations de poussée, et à effectuer une régulation active de la poussée d'un moteur à plasma à partir de la mesure des variations de poussée du moteur.

Ces buts sont atteints grâce à un dispositif de mesure et de régulation de variations de la poussée d'un moteur à plasma à dérive fermée d'électrons comprenant un canal annulaire principal d'ionisation et d'accélération, au moins une cathode creuse disposée à l'extérieur du canal prrincipal en aval de celui-ci, une anode, des moyens d'alimentation en gaz ionisable associés respectivement à la cathode creuse et à l'anode, des moyens de création d'un champ magnétique, et une pluralité de capteurs de flux magnétique disposés autour du canal d'accélération.

Conformément à l'invention, le dispositif comprend en outre une pluralité d'amplificateurs dont les entrées reçoivent les signaux respectifs délivrés par les capteurs de flux magnétique, un circuit sommateur dont les entrées sont reliées aux sorties desdits amplificateurs, et une pluralité de circuits de pondération interposés entre les sorties desdits amplificateurs et le circuit sommateur, chaque circuit de pondération effectuant une pondération du signal émis par un amplificateur à l'aide d'un coefficient déterminé par calibration, et les signaux issus du circuit sommateur sont appliqués à une boucle de contre-réaction d'un circuit de commande d'une vanne de régulation des moyens d'alimentation en gaz ionisable.

Le dispositif de calibration peut comprendre une spire susceptible de prendre plusieurs positions axiales dans le canal d'accélération pour déterminer les coefficients de pondération des circuits de pondération.

Afin de fournir une image directe de la poussée, le dispositif peut en outre comprendre un circuit intégrateur connecté en sortie du circuit sommateur.

Selon un mode particulier de réalisation, le dispositif comprend en outre une pluralité de convertisseurs analogique-numérique disposés respectivement en sortie des amplificateurs, et un multiplexeur dont les entrées reçoivent les signaux issus des convertisseurs analogique-numérique et dont la sortie est reliée à l'entrée du circuit sommateur pour fournir un signal de sortie de type numérique.

Avantageusement, les capteurs de flux magnétique sont constitués par des bobines disposées autour du canal d'accélération.

Dans ce cas, le dispositif comprend de préférence plusieurs bobines servant de capteur de flux magnétique disposées de façon coaxiale au canal d'accélération dans divers plans radiaux différents du canal d'accélération.

Selon un mode particulier de réalisation, certains au moins des capteurs de flux magnétique sont constitués par des bobines alimentées en courant continu faisant partie desdits moyens de création d'un champ magnétique, et ces capteurs de flux magnétique constitués par des bobines alimentées en courant continu sont reliés aux amplificateurs respectifs par l'intermédiaire d'un filtre éliminant la composante continue.

La boucle de contre-réaction peut être de type numérique et la valeur de consigne de la poussée est stockée dans une mémoire.

La boucle de contre-réaction peut cependant également être de type analogique et la valeur de consigne de la poussée est fournie à partir d'un débitmètre massique associé aux moyens d'alimentation en gaz ionisable.

Brève description des dessins

D'autres caractéristiques et avantages de l'invention ressortiront de la description suivante de modes particuliers de réalisation, donnés à titre d'exemples non limitatifs en référence aux dessins annexés, sur lesquels :

- la figure 1 est une vue en élévation et en demi-coupe axiale d'un exemple de moteur à plasma à dérive fermée d'électrons auquel est applicable le dispositif selon l'invention,
- la figure 2 est une vue schématique partielle en demi-coupe axiale du moteur à plasma de la figure 1, montrant une partie d'un dispositif de mesure de variations de poussée selon l'invention,
- les figures 3A à 3D sont des diagrammes montrant un exemple d'évolution de la poussée d'un moteur à plasma et de l'évolution correspondante d'autres grandeurs liées à la poussée,
- la figure 4 est une vue schématique des principaux éléments d'un dispositif de mesure de variations de poussée conforme à l'invention,
- la figure 5 est une vue partielle d'un mode particulier du dispositif de mesure de variations de poussée selon l'invention utilisant des amplificateurs-intégrateurs,
- la figure 6 est une vue partielle d'un mode particulier de dispositif de mesure de variations de poussée selon l'invention, dans lequel des bobines de création d'un champ magnétique faisant partie du moteur à plasma jouent également une fonction de capteurs dans le dispositif selon l'invention,
- la figure 7 est une vue schématique d'un dispositif selon l'invention auquel on a adjoint un élément de calibration pour réaliser une calibration des signaux fournis par les capteurs du dispositif,
- la figure 8 est un schéma montrant l'application du dispositif selon l'invention à une boucle de régulation numérique de la poussée d'un moteur à plasma, et
- la figure 9 est un schéma montrant l'application du dispositif selon l'invention à une boucle de régulation analogique de la poussée d'un moteur à plasma.

Description détaillée de modes particuliers de réalisation

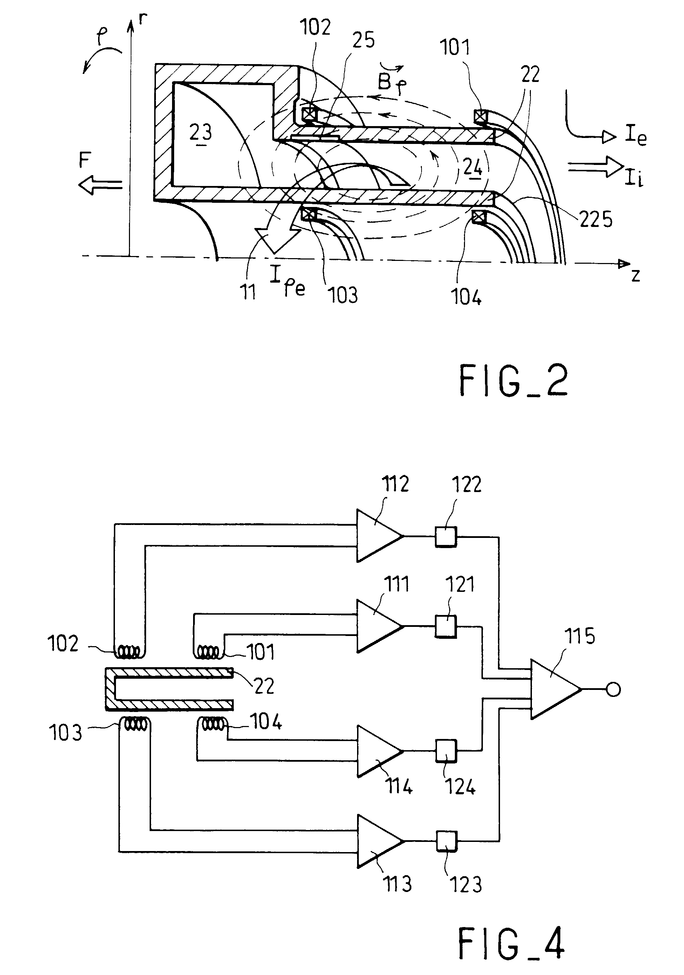

La figure 2 montre de façon schématique une partie de l'exemple de moteur à plasma à dérive fermée d'électrons représenté sur la figure 1.

On a représenté sur la figure 2, les flèches symbolisant le courant ionique Ii et le courant d'électrons Ie en sortie du canal d'accélération 24 du moteur à plasma, ainsi qu'une flèche représentant la poussée F du moteur à plasma. Une flèche 11 symbolise en outre le courant azimutal d'électrons Jpe dans le canal d'accélération 24.

Il a déjà été établi de façon théorique par MM. A. Morozov, Zubkov et Demjanikov, que le courant azimutal d'électrons Jpe est proportionnel à la poussée F dans les moteurs à plasma à dérive fermée d'électrons.

On a ainsi la formule suivante :

$$F = \alpha\!\int jpe\ Hz\ dV$$

soit

$$F = \alpha\ Jpe\ \int(jpe/Jpe)\ HzdV$$

où

$\alpha$ est un coefficient de proportionnalité
V est la tension nette d'accélération
Hz est le champ magnétique dans le canal d'accélération
Jpe est le courant azimutal d'électrons dans le canal d'accélération.
jpe est la densité de courant azimutal

Le courant azimutal d'électrons Jpe n'est pas directement accessible à la mesure.

En revanche, les variations du courant azimutal d'électrons Jpe induisent une variation de flux magnétique dans l'espace situé autour du canal d'accélération du moteur. Cest pourquoi le dispositif 100 de mesure de variations de poussée selon l'invention comprend des capteurs de flux 101 à 104 disposés autour du canal d'accélération 24.

A titre d'exemple, les capteurs de flux 101 à 104 peuvent être constitués par des bobines à air coaxiales au canal d'accélération 24. On peut utiliser par exemple deux paires de bobines 101, 104 et 102, 103 situées l'une (101, 104) au voisinage de la section de sortie 225 du canal d'accélération 24, l'autre (102, 103) au voisinage de l'anode 25 dans la partie du canal d'accélération 24 la plus proche de la chambre tampon 23. D'autres paires de bobines pourraient également être disposées dans des sections intermédiaires par rapport aux sections dans lesquelles sont situées les paires 101, 104 et 102, 103. Chaque paire de bobine 101, 104 et 102, 103 comprend une bobine 101, 102 située dans la partie périphérique extérieure par rapport au canal d'accélération 24 annulaire, et une bobine 104, 103 située dans la partie centrale intérieure par rapport au canal d'accélération 24.

Sur la figure 2, on a également représenté les lignes de l'induction magnétique Bp associée au courant azimutal d'électrons Jpe. Les variations d $\Phi$/dt du flux magnétique $\Phi$ induit par les variations du courant azimutal d'électrons Jpe se traduisent par des variations d'intensité dans les bobines 101 à 104.

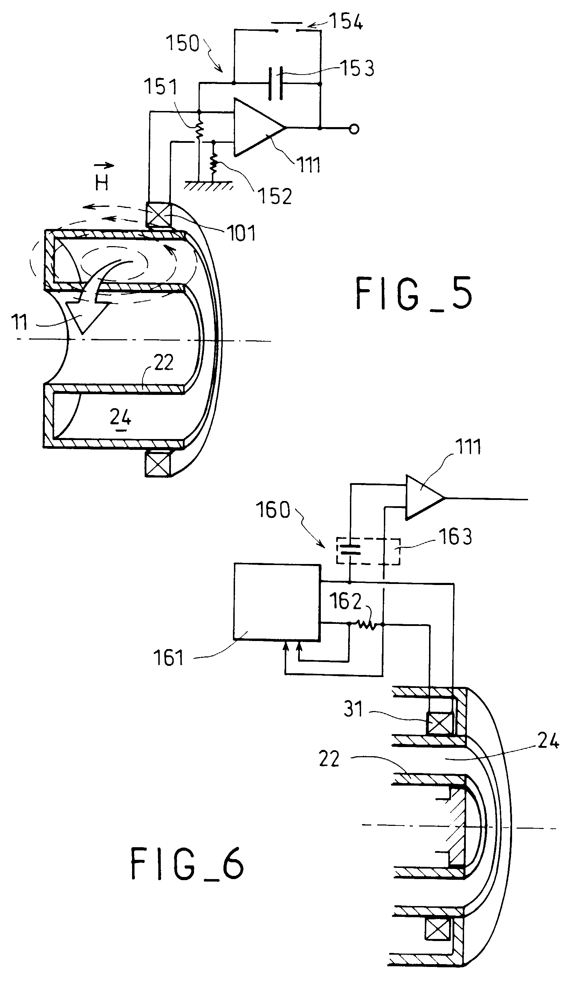

Les bobines 101 à 104 sont connectées aux entrées respectivement de circuits amplificateurs 111 à 114, dont les sorties sont reliées par l'intermédiaire de circuits de pondération 121 à 124 aux entrées d'un circuit sommateur 115 (fig.4)

Chaque circuit de pondération 121 à 124 effectue une pondération du signal émis par un amplificateur 111 à 114 à l'aide d'un coefficient déterminé par calibration.

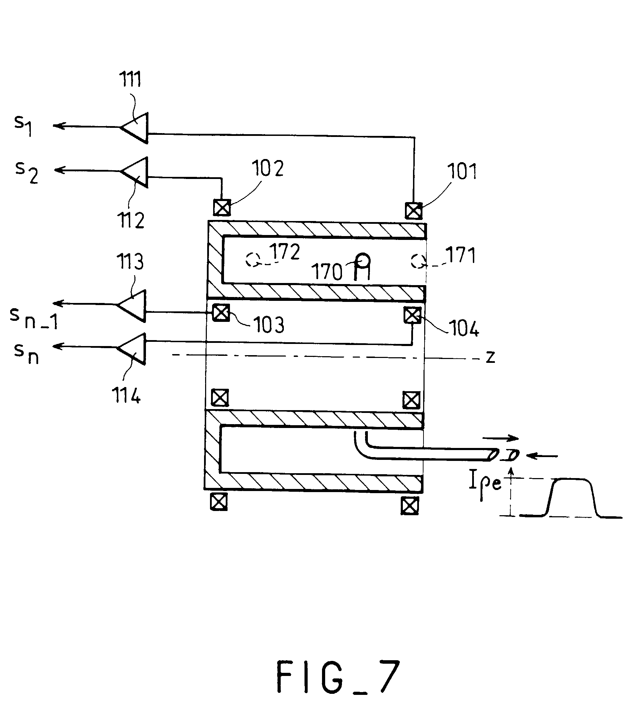

Pour un nombre de bobines ou autres capteurs de flux magnétique 101 à 104 égal à n, la méthode de calibration peut consister à utiliser une spire 170 placée en une première position selon l'axe z du canal d'accélération 24, de façon concentrique au canal, à faire circuler dans la spire 170 un signal de calibration Ipe simulant le courant azimutal d'électrons Jpe, à mesurer les signaux de sortie des n bobines 101 à 104, puis à recommencer l'opération en plaçant la spire 170 en une autre position selon l'axe z du canal d'accélération 24.L'opération doit être répétée k fois pour un nombre k de positions différentes le long de l'axe z, k étant supérieur ou égal au nombre n de bobines 101 à 104. On a représenté en pointillés sur la figure 7 la première position 171 et la k ième position 172 de la spire 170.

On obtient alors une matrice de calibration de dimensions n-k donnant la correspondance entre les signaux de sortie S1, S2,...n des capteurs 101 à 104 et l'intensité du courant de calibration Ic1, Ic2, ..Icn :

$$
\begin{vmatrix} s_1 \\ s_2 \\ s_n \end{vmatrix} = \begin{vmatrix} c11 & c12 & & c1k \\ c21 & c22 & & c2k \\ cn1 & cn2 & & cnk \end{vmatrix} * \begin{vmatrix} I_{c1} \\ I_{c2} \\ I_{cn} \end{vmatrix} \qquad (k \geq n)
$$

Cette matrice permet d'établir les coefficients de sensibilité à affecter au signal $s_i$ de chaque bobine 101 à 104 dans les circuits de pondération 121 à 124, après amplification et avant introduction des signaux dans le circuit sommateur 115.

Selon un mode particulier de réalisation, illustré par la figure 5, les capteurs de variation de flux, tels que la bobine 101, sont reliés à des amplificateurs-intégrateurs 150. Dans ce cas le signal intégré issu de l'amplificateur-intégrateur est proportionnel à l'intensité induite, c'est-à-dire à la variation locale de flux.

La loi liant le signal intégré de chaque bobine telle que la bobine 101, à l'intégrale de l'intensité du courant azimutal d'électrons dans le canal, c'est-à-dire à la poussée peut être obtenue à l'aide de la méthode de calibration décrite plus haut. Le signal de sortie du circuit sommateur 115 de la figure 4 représente ainsi la poussée F selon la formule suivante :

$$
F = a \sum_{i=1}^{n} mj.s_i
$$

où

a : coefficient de proportionnalité

mj : coefficient de pondération prenant en compte le champ magnétique Hz au point j dans le canal d'accélération

$s_i$ : signal de sortie du capteur i

L'amplificateur-intégrateur 150 peut être réalisé de façon simple. On a représenté sur la figure 5 un amplificateur-intégrateur 150 construit autour de l'amplificateur 111 associé à la bobine 101. Des résistances 151, 152 sont connectées entre chaque entrée de l'amplificateur 111 reliée à une extrémité de la bobine 101 et la masse. Un condensateur 153 est connecté entre la sortie de l'amplificateur 111 et l'une des entrées. Un bouton poussoir 154 de remise à zéro est monté en parallèle sur le condensateur 153. Dans le cas du montage sur satellite, le bouton poussoir est bien entendu remplacé par un relais ou un transistor commandé par la logique de bord.

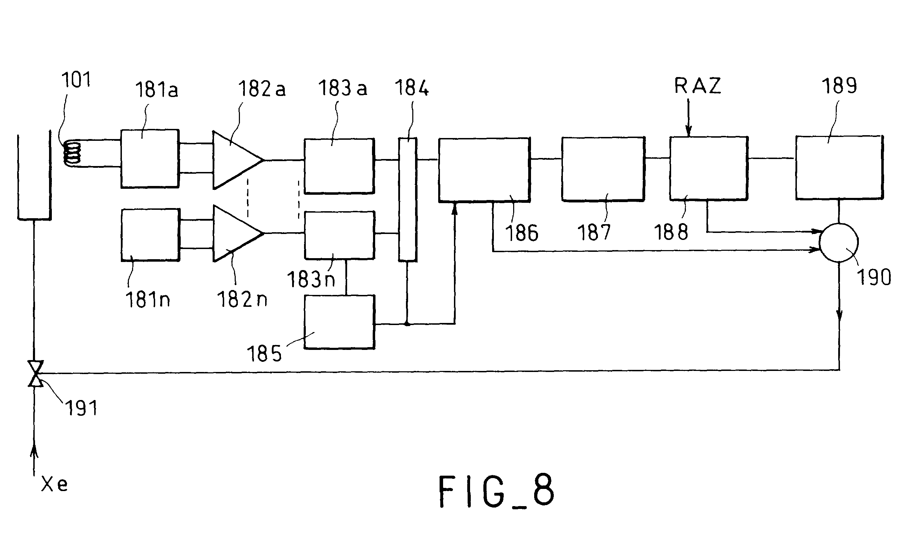

La fonction d'intégration destinée à permettre la reconstitution d'un signal de sortie proportionnel à la poussée, et non aux variations de poussée, peut aussi être assurée en aval du circuit sommateur 115, par exemple de façon numérique, comme cela sera décrit plus loin en référence à la figure 8.

On décrira maintenant en référence à la figure 6 un mode particulier de réalisation du dispositif selon l'invention, applicable à un moteur à plasma à dérive fermée d'électrons tel que celui décrit dans la demande de brevet français 92 08744 déposée le 15 juillet 1992 [WO-A-94/02738 ou EP-A-650 557].

Dans ce cas particulier, les bobines 31 à 33 (voir fig 1) fournissant le champ magnétique peuvent servir de capteur lorsqu'elles sont alimentées en courant continu à partir d'un circuit 161 d'alimentation à intensité constante (fig 6). Un circuit d'adaptation 160 doit cependant être associé à la bobine, telle que la bobine 31 devant servir à la fois de moyen de création d'un champ magnétique dans le canal d'accélération 24 et de capteur de variation de flux magnétique. Le circuit d'adaptation 160 comprend essentiellement un filtre 163 comprenant un condensateur de liaison entre une extrémité de la bobine 31 et une entrée de l'amplificateur 111, afin d'éliminer la composante continue à l'entrée de l'amplificateur 111. Une résistance 162 est connectée entre le circuit d'alimentation à intensité constante 161 et l'une des extrémités de la bobine 31 afin de contrôler l'intensité du courant continu délivré à la bobine 31.

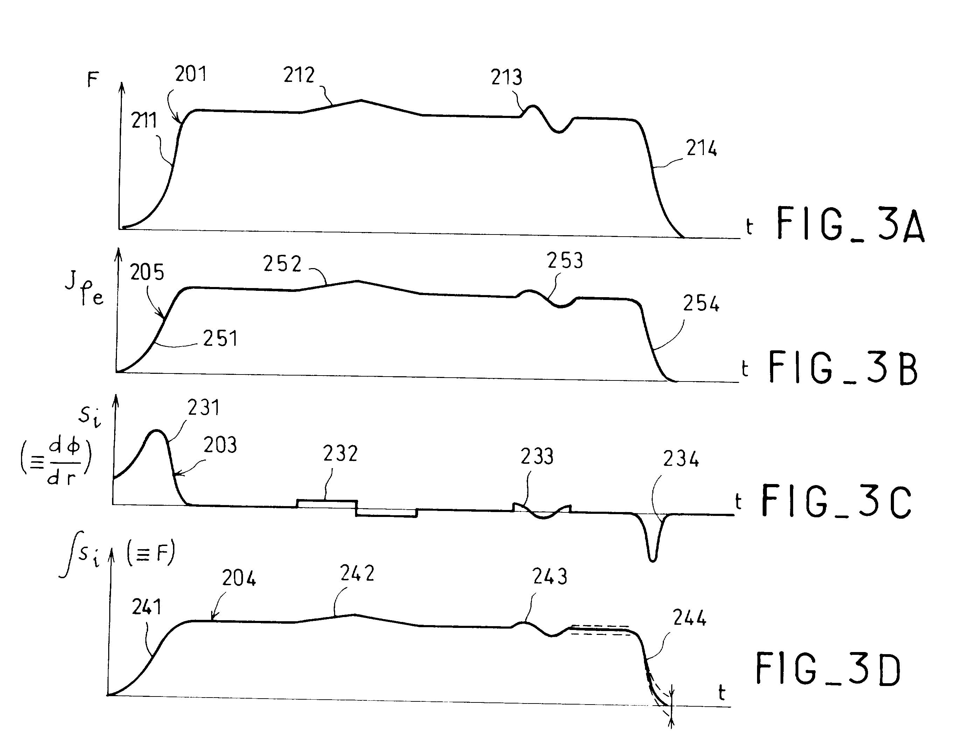

La figure 3A montre un exemple de variations de la poussée F d'un moteur à plasma en fonction du temps. La courbe 201 présente dans ce cas un front montant 211, une irrégularité triangulaire 212 et une irrégularité sinusoïdale 213 dans la partie de la courbe 201 en forme de plateau, et un front descendant 214.

La figure 3B montre la forme de la courbe 205 correspondant à l'intensité du courant azimutal d'électrons Jpe pour l'évolution de la poussée F représentée sur la figure 3A. On note la correspondance de forme avec des zones 251 à 254 de la courbe 205 qui correspondent tout-à-fait aux zones 211 à 214 de la courbe 201.

La figure 3C montre la forme de la courbe 203 des signaux Si délivrés par les capteurs 101 à 104 de variations de flux magnétique en correspondance avec les variations de poussée F représentées sur la figure 3A. On notera que les parties 231, 232, 233, 234 de la courbe 203 correspondent bien à la dérivée de la courbe 201 de la figure 3A et permettent de déceler les zones de variation 211 à 214 de l'amplitude de la courbe 201 correspondant à la poussée.

La figure 3D montre la reconstitution d'une courbe 204 par intégration du signal illustré par la courbe 203 de la figure 3C. On voit que la courbe reconstituée 204 correspond bien à la courbe 201 de la figure 3A relative à la poussée F.

Les signaux délivrés par les bobines 101 à 104 du dispositif de détection peuvent être utilisés de plusieurs manières différentes.

Selon une première application, on exploite les signaux après intégration afin d'obtenir un signal représentant la poussée et de corriger éventuellement cette poussée dans une boucle de régulation, par action sur le débit de gaz propulsif injecté dans le moteur. Ce type d'application est particulièrement utile au cours du démarrage du moteur.

Le circuit intégrateur peut être de type analogique et combiné aux circuits amplificateurs 111 à 114, comme décrit en référence à la figure 5. Le circuit intégrateur peut également être placé en sortie du circuit sommateur 115 et être distinct des amplificateurs 111 à 114. Un intégrateur de type analogique est toutefois susceptible de présenter une dérive. C'est pourquoi il peut être avantageux de mettre en oeuvre un circuit intégrateur de type numérique, comme cela va être décrit en référence à la figure 8.

La figure 8 représente un exemple de boucle de régulation numérique dans laquelle les bobines telle que la bobine 101 sont reliées par l'intermédiaire de filtres passe-bas 181a ... 181n aux entrées d'amplificateurs 182a ... 182n dont les sorties sont elles-mêmes reliées aux entrées de convertisseurs analogique-numérique (CAN) 183a, ... 183n. Les sorties des convertisseurs analogique-numérique 183a... 183n sont reliées à un multiplexeur 184 cadencé par une horloge 185. La sortie du multiplexeur 184 est connectée à un circuit sommateur 186 qui fournit un signal numérique représentatif des variations de poussée à un comparateur 190. Un circuit intégrateur numérique 188 est connecté en sortie du circuit sommateur 187 pour fournir au comparateur 190 une image de la poussée F. L'intégrateur 188, qui possède une entrée de remise à zéro assure une mémorisation de la valeur intégrée. Un circuit 189 délivre par ailleurs au comparateur 190 une consigne de poussée. La sortie du comparateur 190 sert à commander une vanne de régulation 191 placée sur le circuit d'alimentation du moteur en gaz propulsif ionisable.

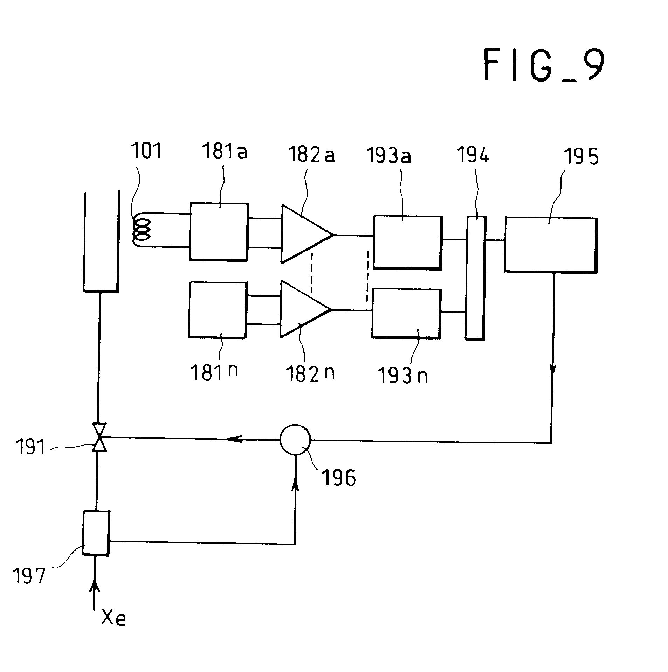

La figure 9 illustre un autre exemple d'application du dispositif de détection selon l'invention. Dans ce cas, on utilise directement les signaux délivrés par les bobines telles que les bobines 101 à 104, après amplification et sommation, mais sans effectuer d'intégration. On se sert ainsi des signaux représentant la dérivée de la poussée comme ceux illustrés sur la figure 3C, pour réaliser une contre-réaction sur le débit d'alimentation en gaz propulsif et ainsi obtenir une poussée constante.

Sur la figure 9 on voit ainsi les capteurs tels que la bobine 101 qui sont connectés par l'intermédiaire de filtres passe-bas 181a.... 181n à des amplificateurs 182a... 182n dont les sorties sont reliées par des circuits 193a... 193n d'adaptation de niveau, pouvant correspondre aux circuits 121 à 124 de la figure 4, à des circuits sommateurs 194, 195 dont la sortie est reliée à un comparateur 196 auquel est également appliqué un signal de référence constitué par le signal délivré par un débitmètre massique 197 placé sur la ligne d'alimentation du moteur en gaz propulsif. La sortie du comparateur 196 sert à commander une vanne de régulation 191 également placée sur la ligne d'alimentation du moteur en gaz propulsif.

Le dispositif selon l'invention de mesure de la dérivée de poussée, et par intégration, de mesure de la poussée elle-même présente les avantages suivants :

* au sol, pendant les essais de recette, une mesure électrique est plus simple qu'une mesure par balance de poussée ;
* il permet de simplifier le contrôle orbital d'un satellite géostationnaire : en effet, il est possible de délivrer une correction parfaitement calibrée en connaissant le temps de fonctionnement du moteur et la poussée, l'effet de cette dernière étant parfaitement prévisible, de sorte que les contrôles des paramètres orbitaux peuvent être ainsi espacés.
* il permet de contribuer à l'équilibre d'attitude d'un satellite en maintenant égales les poussées de deux moteurs tirant dans la même direction,
* un dispositif de mesure et régulation de poussée permet d'annuler un éventuel déséquilibre de poussée entre deux moteurs en tir simultané, cette perturbation relative de l'attitude du satellite est donc éliminée. Inversement, pour des besoins propres au satellite, par exemple pour une désaturation des roues de réaction, on peut volontairement créer une différence de poussée entre les deux moteurs induisant un couple connu.
* la possibilité de réguler directement la poussée permet d'effectuer un contrôle actif de la traînée pour des satellites en orbite basse.

## Revendications

1. Dispositif de mesure et de régulation de variations de la poussée d'un moteur à plasma à dérive fermée d'électrons comprenant un canal annulaire principal d'ionisation et d'accélération (24), au moins une cathode creuse (40) disposée à l'extérieur du canal principal en aval de celui-ci, une anode (25), des moyens (41,26) d'alimentation en gaz ionisable associés respectivement à la cathode creuse (40) et à l'anode (25), des moyens (31 à 33) de création d'un champ magnétique et une pluralité de capteurs de flux magnétique (101 à 104; 31 à 33) disposés autour du canal d'accélération (24), caractérisé en ce qu'il comprend en outre une pluralité d'amplificateurs (111 à 114) dont les entrées reçoivent les signaux respectifs délivrés par les capteurs de flux magnétique (101 à 104; 31 à 33), un circuit sommateur (115) dont les entrées sont reliées aux sorties desdits amplificateurs (111 à 114), et une pluralité de circuits de pondération (121 à 124) interposés entre les sorties desdits amplificateurs (111 à 114) et le circuit sommateur (115), chaque circuit de pondération (121 à 124) effectuant une pondération du signal émis par un amplificateur à l'aide d'un coefficient déterminé par calibration, et en ce que les signaux issus du circuit sommateur (115 ; 186 ; 195) sont appliqués à une boucle de contre-réaction (190 ; 196) d'un circuit de commande d'une vanne (191) de régulation des moyens (41, 26) d'alimentation en gaz ionisable.

2. Dispositif selon la revendication 1, caractérisé en ce qu'il comprend en outre un circuit intégrateur (187) connecté en sortie du circuit sommateur (186) pour fournir une image directe de la poussée et réaliser un asservissement de poussée à l'aide d'une boucle de régulation (190,196) comprenant au moins une entrée recevant le signal du circuit sommateur (186), une entrée recevant le signal du circuit intégrateur (187), une entrée recevant une valeur de consigne de poussée et une sortie agissant sur ladite vanne de régulation (191).

3. Dispositif selon l'une quelconque des revendications 1 et 2, caractérisé en ce qu'il comprend en outre une pluralité de convertisseurs analogique-numérique (183a, 183b) disposés respectivement, en sortie des amplificateurs (111 à 114 ; 182a, 182b), et un multiplexeur (184) dont les entrées reçoivent les signaux issus des convertisseurs analogique-numérique (183a, 183b) et dont la sortie est reliée à l'entrée du circuit sommateur (115 ; 186) pour fournir un signal de sortie de type numérique.

4. Dispositif selon l'une quelconque des revendications 1 à 3, caractérisé en ce que sa calibration est assurée à l'aide d'une spire (170) susceptible de prendre plusieurs positions axiales (171, 172) dans le canal d'accélération (24) pour déterminer les coefficients de pondération des circuits de pondération (121 à 124).

5. Dispositif selon l'une quelconque des revendications 1 à 4, caractérisé en ce que les capteurs de flux magnétique (101 à 104) sont constitués par des bobines disposées autour du canal d'accélération (24).

6. Dispositif selon la revendication 5, caractérisé en ce qu'il comprend plusieurs bobines servant de capteur de flux magnétique (101, 104 ; 102, 103) disposées de façon coaxiale au canal d'accélération (24) dans divers plans radiaux différents du canal d'accélération (24).

7. Dispositif selon la revendication 5, caractérisé en ce que certains au moins des capteurs de flux magnétique sont constitués par des bobines (31 à 33) alimentées en courant continu faisant partie desdits moyens de création d'un champ magnétique, et en ce que ces capteurs de flux magnétique constitués par des bobines (31 à 33) alimentées en courant continu sont reliés aux amplificateurs (111) respectifs par l'intermédiaire d'un filtre (163) éliminant la composante continue.

8. Dispositif selon l'une quelconque des revendications 1 à 7, caractérisé en ce que la boucle de contre-réaction (190) est de type numérique et la valeur de consigne de la poussée est stockée dans une mémoire (189).

9. Dispositif selon l'une quelconque des revendication 1 à 7, caractérisé en ce que la boucle de contre-réaction (196) est de type analogique et la valeur de consigne de la poussée est fournie à partir d'un débitmètre massique (197) associé aux moyens (41, 26) d'alimentation en gaz ionisable.

**Patentansprüche**

1. Meß- und Regelvorrichtung für die Schubänderungen eines Hall-Motors, der ein ringförmiges Hauptionisations- und Beschleunigungsrohr (24) aufweist, mindestens eine Hohlkathode (40), die außerhalb des Hauptrohrs stromabwärts davon angeordnet ist, eine Anode (25), Versorgungsvorrichtungen (41, 26) für das ionisierbare Gas, die jeweils an die Hohlkathode (40) und an die Anode (25) angeschlossen sind, Vorrichtungen (31-33) für die Erzeugung eines magnetischen Feldes und eine Vielzahl von Meßfühlern für die magnetische Flußdichte (101-104; 31-33), die um das Beschleunigungsrohr (24) angeordnet sind,
dadurch gekennzeichnet, daß
sie darüber hinaus eine Vielzahl von Verstärkern (111-114) aufweist, deren Eingänge die Signale erhalten, die jeweils durch die Meßfühler für die magnetische Flußdichte (101-104; 31-33) ausgesendet werden, ein Summationsschaltung (115), der Eingänge an die Ausgänge der Verstärker (111-114) angeschlossen sind und eine Vielzahl von Wichtungsschaltungen (121-124), die zwischen den Ausgängen der Verstärker (111-114) und der Summationsschaltung (115) angeordnet sind, wobei jede Wichtungsschaltung (121-124) eine Wichtung des Signals mit Hilfe eines durch Kalibrierung bestimmten Koeffizienten vornimmt, das durch den Verstärker ausgesendet wird, und dadurch, daß die Signale der Summationsschaltung (115; 186; 195) an eine Gegenreaktionsschleife (190; 196) einer Steuerungsschaltung eines Ventils (191) für die Regelung der Versorgungsvorrichtungen (41, 26) für das ionisierbare Gas angelegt werden.

2. Vorrichtung nach Anspruch 1, dadurch gekennzeichnet, daß sie darüber hinaus eine Integrationsschaltung (187) aufweist, die an den Ausgang der Summationsschaltung (186) angeschlossen ist, um ein direktes Abbild des Schubes abzugeben und eine Regelung des Schubes mit Hilfe einer Regelschleife (190, 196) zu ermöglichen, die mindestens einen Eingang aufweist, der das Signal der Summationsschaltung (186) empfängt, einen Eingang, der das Signal der Integrationsschaltung (187) empfängt, einen Eingang, der einen Soll-Schubwert empfängt und einen Ausgang, der das Regelventil (191) regelt.

3. Vorrichtung nach einem der vorherigen Ansprüche 1 und 2, dadurch gekennzeichnet, daß sie darüber hinaus eine Vielzahl von Analog/Digital-Konvertern (183a, 183b) aufweist, die jeweils am Ausgang der Verstärker (111-114; 182a, 182b) angeordnet sind und einen Multiplexer (184), dessen Eingänge die Signale der Analog/Digital-Konverter (183a, 183b) empfangen und dessen Ausgang an den Eingang des Summationsschaltkreises (115; 186) angeschlossen ist, um ein digitales Ausgangssignal abzugeben.

4. Vorrichtung nach einem der vorherigen Ansprüche 1 bis 3, dadurch gekennzeichnet, daß ihre Kalibrierung mit Hilfe eines Schraubenganges (170) vorgenommen wird, der mehrere axiale Positionen (171, 172) im Beschleunigungsrohr (24) einnehmen kann, um die Wichtungskoeffizienten der Wichtungsschaltungen (121-124) zu bestimmen.

5. Vorrichtung nach einem der vorherigen Ansprüche 1 bis 4, dadurch gekennzeichnet, daß die Meßfühler für den magnetischen Fluß (101-104) aus Spulen bestehen, die um das Beschleunigungsrohr (24) angeordnet sind.

6. Vorrichtung nach Anspruch 5, dadurch gekennzeichnet, daß sie mehrere Spulen aufweist, die als Meßfühler für die magnetische Flußdichte (101, 104; 102, 103) dienen, die koaxial zum Beschleunigungsrohr (24) in verschiedenen unterschiedlichen radialen Ebenen des Beschleunigungsrohrs (24) angeordnet sind.

7. Vorrichtung nach Anspruch 5, dadurch gekennzeichnet, daß wenigstens einige der Meßfühler für die magnetische Flußdichte aus Spulen (31-33) bestehen, die mit Gleichstrom versorgt werden, der Teil der Vorrichtung für die Erzeugung eines magnetischen Feldes ist und dadurch, daß die Meßfühler für die magnetische Flußdichte, die aus Spulen (31-33) bestehen, die mit Gleichstrom versorgt werden, jeweils an Verstärker (111) durch einen Filter (163) angeschlossen sind, der die Gleichstromkomponente unterdrückt.

8. Vorrichtung nach einem der vorherigen Ansprüche 1 bis 7, dadurch gekennzeichnet, daß die Gegenreaktionsschleife (190) digital ist und daß der Soll-Schubwert in einem Speicher (189) gespeichert ist.

9. Vorrichtung nach einem der vorherigen Ansprüche 1 bis 7, dadurch gekennzeichnet, daß die Gegenreaktionsschleife (196) analog ist und der Soll-Schubwert von einem Massendurchflußmeter (197) geliefert wird, der an die Versorgungsvorrichtungen (41, 26) für das ionisierbare Gas angeschlossen ist.

## Claims

1. A device for measuring and regulating variations in the thrust of a plasma accelerator with closed electron drift comprising a main annular channel (24) for ionization and acceleration, at least one hollow cathode (40) disposed outside the main channel and downstream therfrom, an anode (25), ionizable gas feed means (41, 26) associated respectively with the hollow cathode (40) and with the anode (25), and magnetic field creation means (31 to 33) and a plurality of magnetic flux sensors (101 to 104; 31 to 33) disposed around the acceleration channel (24), the device being characterized in that it further comprises a plurality of amplifiers (111 to 114) whose inputs receive the respective signals delivered by the magnetic flux sensors (101 to 104; 31 to 33), a summing circuit (115) whose inputs are connected to the outputs of said amplifiers (111 to 114), and a plurality of weighting circuits (121 to 124) interposed between the outputs of said amplifiers (111 to 114) and the summing circuit (115), each weighting circuit (121 to 124) weighting the signal from an amplifier with a coefficient that has been determined by calibration, and in that the signals from the summing circuit (115; 186; 195) are applied to a negative feedback loop (190; 196) in a circuit for controlling a valve (191) that regulates the ionizable gas feed means (41, 26).

2. A device according to claim 1, characterized in that it further comprises an integrator circuit (187) connected at the output of the summing circuit (186) to provide a direct image of the thrust and carry out an automatic thrust control using a regulation loop (190; 196) that comprises at least one input receiving the signal from the summing circuit (186), one input receiving the signal from the integrator circuit (187), one input receiving a reference value for the thrust and one output acting against said regulation valve (191).

3. A device according to any one of claims 1 and 2, characterized in that it further comprises a plurality of analog-to-digital converters (183a, 183b) respectively disposed at the outputs of the amplifiers (111 to 114; 182a, 182b), and a multiplexer (184) whose inputs receive the signals from the analog-to-digital converters (183a, 183b) and whose output is connected to the input of the summing circuit (115; 186) to provide a digital type output signal.

4. A device according to any one of claims 1 to 3, characterized in that calibration thereof is performed by means of a single-turn coil (170) suitable for taking up a plurality of axial positions (171, 172) in the acceleration channel (24) to determine the weighting coefficients of the weighting circuits (121 to 124).

5. A device according to any one of claims 1 to 4, characterized in that the magnetic flux sensors (101 to 104) are constituted by coils disposed around the acceleration channel (24).

6. A device according to claim 5, characterized in that it comprises a plurality of coils serving as magnetic flux sensors (101, 104; 102, 103) disposed coaxially with the acceleration channel (24) in various radial planes that are different from the acceleration channel (24).

7. A device according to claim 5, characterized in that at least some of the magnetic flux sensors are constituted by coils (31 to 33) fed with DC and forming part of said magnetic field creation means, and in that said magnetic flux sensors constituted by coils (31 to 33) fed with DC are connected to respective amplifiers (111) via a filter (163) eliminating the DC component.

8. A device according to any one of claims 1 to 7, characterized in that the negative feedback loop (190) is of the digital type, and the reference value for the thrust is stored in a memory (189).

9. A device according to any one of claims 1 to 7, characterized in that the negative feedback loop (196) is of the analog type, and the reference value for the thrust is provided from a mass flow meter (197) associated with the ionizable gas feed means (41, 26).

# FIG_1

FIG_2

FIG_4

FIG_3A

FIG_3B

FIG_3C

FIG_3D

$F$

$J\rho e$

$Si\ \left(\equiv \dfrac{d\phi}{dr}\right)$

$\int Si\ (\equiv F)$

201, 211, 212, 213, 214

205, 251, 252, 253, 254

231, 203, 232, 233, 234

241, 204, 242, 243, 244

$t$

FIG_5

FIG_6

FIG_7

FIG_8

FIG_9